## Europäisches Patentamt
## European Patent Office
## Office européen des brevets

(19)

(11) Publication number: **0 129 385**
**A2**

(12) # EUROPEAN PATEENT APPLICATION

(21) Application number: **84303924.9**

(22) Date of filing: **11.06.84**

(51) Int. Cl.³: **H 01 L 29/72**
**H 01 L 29/08**

(30) Priority: **17.06.83 GB 8316559**

(43) Date of publication of application:
**27.12.84 Bulletin 84/52**

(84) Designated Contracting States:
**DE FR IT NL SE**

(71) Applicant: **PLESSEY OVERSEAS LIMITED**
**Vicarage Lane**
**Ilford Essex IGI 4AQ(GB)**

(72) Inventor: **Ward, Peter John**
**Wensum Church Street**
**Charwelton Northants(GB)**

(72) Inventor: **Duffill, Jennifer Elizabeth**
**59 Glebe Crescent**
**Rugby Warwickshire(GB)**

(74) Representative: **Thorne, Kenneth John**
**The Plessey Company PLC Intellectual Property**
**Department 2-60 Vicarage Lane**
**Ilford Essex IG1 4AQ(GB)**

(54) Improvements in bipolar transistors.

(57) A bipolar transistor comprises collector, base and emitter layers (12, 11, 10) of semiconductor material. The doping density of the base layer (11) is arranged to provide a sub emitter base resistivity of less than 5 kilohms. An oxygen rich layer (14) of the semiconductor material is provided between the emitter layer (10) and an electrode connection (15). The current gain which results is greater than 100.

FIG.3.

EP 0 129 385 A2

Croydon Printing Company Ltd.

0129385

## IMPROVEMENTS IN BIPOLAR TRANSISTORS

This invention relates to bipolar transistors and more particularly but not solely to silicon bipolar transistors.

A conventional bipolar transistor comprises a three layer device having a heavily doped emitter with lighter doped base and collector regions. The collector current gain or amplification factor of such devices is the ratio of collector current Ic to base current Ib and is normally influenced by the properties of the base layer. The doping density of the base layer is a compromise between speed of operation and current gain. An increased doping results in reduced base resistance and consequently increased switching speed, but also results in increased base current and reduced current gain. Reduced doping increases the base resistance and reduces switching speed but increases current gain.

In practice the current gain is substantially proportional to the sub emitter base resistivity and as a rough guide a sub emitter resistivity of 10 kilohms results in a maximum amplification factor of 100, ie. a ratio of current gain: resistivity in kilohms of 10:1, clearly a reduction of base resistivity to 5 kilohms results in a reduction of current gain to 50. The present invention seeks to provide a bipolar transistor in which this ratio is increased.

According to the invention there is provided a Bipolar transistor comprising collector base and emitter layers of semiconductor material wherein the base layer doping density is arranged to provide a sub emitter base resistivity of less than 5 kilohms per square and an oxygen rich layer of the semiconductor material is provided between the emitter layer and the emitter electrode connection, whereby the current gain is greater than 100. The employment of the oxygen rich layer results in a reduction of base current and increased current gain for a given structure. Accordingly the ratio of current gain to resistivity is increased.

The invention is of particular application to transistors manufactured from silicon.

Preferably the ratio of sub emitter base resistivity to current gain is at least equal to 100:1.

In a particularly advantageous construction the sub emitter base resistivity is substantially 1 kilohm and the transistor has a current gain of 150.

In order that the invention and its various other preferred features may be understood more easily, some embodiments thereof will now be described, by way of example only, with reference to the drawings, in which:-

Figure 1 is a cross sectional view taken through a bipolar transistor of known type, only part of the device being shown.

Figure 2 is a circuit symbol of the transistor of Figure 1, showing electrode currents.

Figure 3 is cross sectional view taken through a bipolar transistor constructed in accordance with the invention, only part of the device being shown.

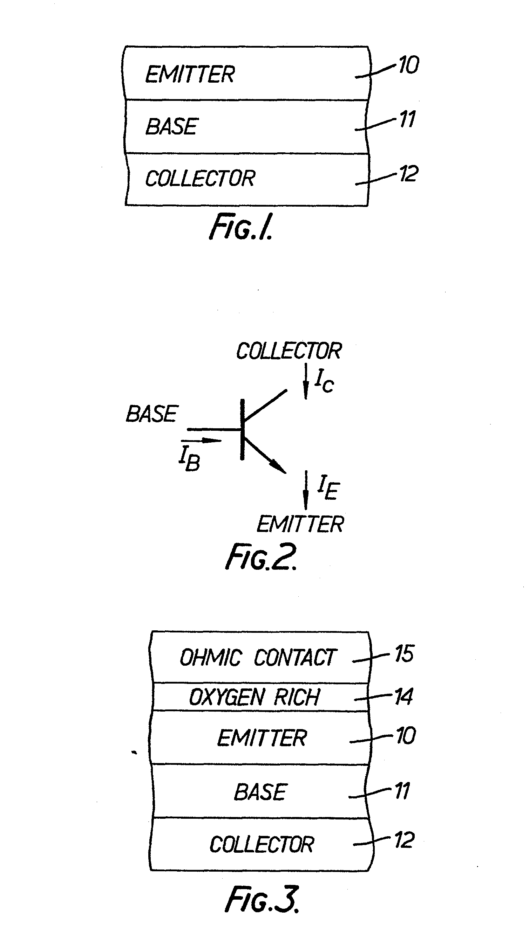

The diagram of Figure 1 shows a conventional silicon bipolar transistor having three superposed layers. The layers consist of a heavily doped emitter layer 10 with more lightly doped base layer 11 and collector layer 12.

The base layer is formed of opposite conductivity type semiconductor material to that of the emitter and collector layers. This device is represented in Figure 2 as a three terminal device, which when connected to appropriate power supplies, passes the indicated collector, base and emitter currents Ic, Ib and Ie respectively.

The fundamental useful property of this device is that Ic is greater than Ib which, in electrical circuit terms, gives amplification. In conventional devices the properties of layer 10 (Figure 1) determine the size of Ib, specifically, layer 10 is doped to the maximum physically possible to reduce Ib to the minimum. Thus, for a given emitter layer there is a minimum value of Ic to maintain amplification, which in turn determines the maximum permissible doping level of the base region, layer 11. This maximum permissible doping of the base to maintain amplification manifests itself as a resistance in the base layer which limits the speed of operation of the transistor.

It has been shown in an article in I.E.E Transactions on Electronic Devices Volume ED-26 p1771 (1979) by H C de Graaf and J G de Groot that the introduction of an oxygen rich silicon layer between the emitter silicon and its ohmic contact, substantially reduces the magnitude of Ib. The disclosure in that article is hereby incorporated by reference to explain the provision of such a layer in a bipolar structure and to show the properties resulting.

A bipolar transistor in accordance with the invention is illustrated in Figure 3 and comprises a three layer structure similar to that illustrated in Figure 1 but in which an oxygen rich layer 14 is provided between the emitter layer and an ohmic contact 15 in the manner proposed by de Graaf and de Groot. However, the doping of the base layer 11, which is carried out by conventional techniques, is increased compared with conventional bipolar transistors to levels which result in a sub emitter base resistivity which would not normally provide a useful value of current gain thereby taking advantage of the properties introduced by the layer 14 which suppresses base current.

In practice the sub emitter base resistivity has been reduced to a value of 1 kilohm per square whilst still maintaining a current gain of 150. A sub emitter base resistivity of 5 kilohms per square or less has been shown to provide a useful construction in that it provides a current gain substantially greater than 100. In practice sub emitter base resistivity and current gain are substantially proportional and a 5 kilohm per square resistivity will provide a current gain of 750. In conventional bipolar constuction, a current gain of approximately 50 results for a 5 kilohm square resistivity ie, the present construction has an improvement in current gain of 15 times.

By substantially reducing the base resistance as compared with conventional bipolar transistors, the speed or frequency of operation can be substantially increased and the invention enables the construction of a bipolar transistor which will operate at frequences of 10 G.Hz as compared with 3 G.Hz with conventional bipolar devices.

Although the preferred semiconductor material is silicon the device could be manufactured from other semiconductor materials without departing from the scope of this invention.

CLAIMS

1.  A Bipolar transistor comprising collector base and
emitter layers of semiconductor material wherein the base
layer doping density is arranged to provide a sub emitter base
resistivity of less than 5 kilohms per square and an oxygen
rich layer of the semiconductor material is provided between
the emitter layer and the emitter electrode connection,
whereby the current gain is greater than 100.

2.  A transistor as claimed in claim 1 formed from silicon.

3.  A transistor as claimed in claim 1 or 2 wherein the ratio
of the sub emitter base resistivity in kilohms per square to
current gain is at least 100:1.

4.  A transistor as claimed in claim 1, 2 or 3 wherein the
sub emitter base resistivity is substantially 1 kilohm per
square and the transistor has a current gain of 150.

5.  A transistor substantially as described herein with
reference to Figure 3 of the drawings.

| EMITTER | 10 |
| BASE | 11 |
| COLLECTOR | 12 |

**FIG.1.**

COLLECTOR $\downarrow I_C$

BASE $\overrightarrow{I_B}$

$\downarrow I_E$

EMITTER

**FIG.2.**

| OHMIC CONTACT | 15 |
| OXYGEN RICH | 14 |
| EMITTER | 10 |
| BASE | 11 |
| COLLECTOR | 12 |

**FIG.3.**